# EUROPEAN PATENT APPLICATION

(11) **EP 4 823 303 A1**
(43) Date of publication of application: **14.10.2026**
(21) Application number: 24964339.6
(22) Date of filing: 25.12.2024
(51) Int. Cl.: H10K 59/50

(54) **DISPLAY PANEL AND DISPLAY APPARATUS**

(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: LI, Shuo, Beijing 100176 (CN); SHI, Ling, Beijing 100176 (CN); HUANG, Yinglong, Beijing 100176 (CN); LI, Yuxiao, Beijing 100176 (CN); LIU, Rui, Beijing 100176 (CN); LI, Zhen, Beijing 100176 (CN); ZHAO, Yunshan, Beijing 100176 (CN); LIU, Jiang, Beijing 100176 (CN)
(74) Representative: Brötz, Helmut
(86) International application number: PCT/CN2024/142489
(87) International publication number: WO 2026/137283

(57) **Abstract**

A display panel and a display apparatus. The display panel comprises: a base substrate (BS); a plurality of subpixels (100), which are located on the base substrate (BS), each subpixel (100) comprising a light-emitting region (160); and a black matrix (200), which comprises a plurality of openings (201), one opening (201) being correspondingly provided outside the light-emitting region (160) of each subpixel (100), wherein for the same subpixel (100), the distance between the orthographic projection of the opening on the base substrate (BS) and the orthographic projection of the light-emitting region on the base substrate (BS) is an outward expansion value (K), and the outward expansion values of at least three of subpixels adjacent to the same subpixel (100) are different from the outward expansion value of the subpixel, so as to mitigate diffraction, thereby improving the display quality.

## Description

### TECHNICAL FIELD

At least one embodiment of the present disclosure relates to a display panel and a display apparatus.

### BACKGROUND

With the continuous development of display technologies, organic light-emitting diode (OLED) display apparatuses have gradually become mainstream display apparatuses due to advantages such as self-emissive characteristics, wide color gamut, light weight and thin profile, high contrast ratio, fast response speed, low power consumption, and flexible display capability.

Conventional OLED display apparatuses suffer from reflection and glare issues under ambient light irradiation. Accordingly, a color filter on encapsulation (COE) technology has been proposed. By forming a color filter structure on the encapsulation layer of the OLED display apparatus, ambient light can be effectively absorbed and scattered, thereby greatly reducing surface reflection of the screen and alleviating glare phenomena. Meanwhile, the COE technology can also improve light transmittance, so that displayed images are brighter and more delicate, and color reproduction is more accurate.

### SUMMARY

At least one embodiment of the present disclosure provides a display panel and a display apparatus.

At least one embodiment of the present disclosure provides a display panel, including: a base substrate; a plurality of sub-pixels located on the base substrate, each sub-pixel of the plurality of sub-pixels including a light-emitting region; and a black matrix including a plurality of openings, one opening of the plurality of openings being correspondingly disposed outside the light-emitting region of each sub-pixel of the plurality of sub-pixels; at the same sub-pixel, a distance between an orthographic projection of the opening on the base substrate and an orthographic projection of the light-emitting region on the base substrate is an outward value, and among sub-pixels adjacent to the same sub-pixel, at least three sub-pixels have outward values different from that of the sub-pixel.

For example, the plurality of sub-pixels form a plurality of repeating units, each repeating unit of the plurality of repeating units includes at least one repeating sub-unit, in the at least one repeating sub-unit, each repeating sub-unit includes a first sub-pixel, a second sub-pixel, and a third sub-pixel, and each two of the first sub-pixel, the second sub-pixel, and the third sub-pixel have different light-emitting colors.

For example, outward values of the first sub-pixel, the second sub-pixel, and the third sub-pixel in the same repeating sub-unit are different from one another.

For example, each repeating unit of the plurality of repeating units includes a plurality of repeating sub-units, and in at least three different repeating sub-units, outward values of first sub-pixels are different, outward values of second sub-pixels are different, and outward values of third sub-pixels are different.

For example, along an arrangement direction of three different repeating sub-units, outward values of first sub-pixels increase sequentially, outward values of second sub-pixels increase sequentially, and outward values of third sub-pixels increase sequentially.

For example, outward values of sub-pixels in the same repeating sub-unit are identical, and outward values in at least three different repeating sub-units are different.

For example, each repeating unit of the plurality of repeating units includes six repeating sub-units, and the six repeating sub-units form a matrix of three rows and three columns; and in the matrix, in a row direction, in at least one row of repeating sub-units, outward values K of three repeating sub-units are different from one another.

For example, in a column direction, in at least one column of repeating sub-units, at least two different repeating sub-units have different outward values.

For example, in the row direction, in each of the three rows of repeating sub-units, the outward values K of the three repeating sub-units are different from one another; and in the column direction, in each of the three columns of repeating sub-units, the outward values of at least two different repeating sub-units are different.

For example, in the column direction, in one column of the three columns of repeating sub-units, outward values of three different repeating sub-units are different from one another.

For example, the outward value is greater than or equal to 1 µm and less than or equal to 4 µm.

For example, the plurality of sub-pixels include a plurality of first sub-pixels, a plurality of second sub-pixels, and a plurality of third sub-pixels, and each two of each of the plurality of first sub-pixels, each of the plurality of second sub-pixels, and each of the plurality of third sub-pixels have different light-emitting colors; and the display panel satisfies at least one of the following three conditions regarding different outward values: at least two first sub-pixels have different outward values, at least two second sub-pixels have different outward values, or at least two third sub-pixels have different outward values.

For example, a minimum gap between different outward values among a plurality of outward values is greater than or equal to 0.5 µm.

For example, the display panel further includes a color filter layer, an insulating layer is disposed between the color filter layer and the black matrix, the color filter layer is closer to the base substrate than the black matrix, and the insulating layer covers the color filter layer.

For example, at least one opening among the plurality of openings is non-circular in shape, the opening of the black matrix has a major axis, a dimension of the opening in an extending direction of the major axis is a maximum dimension of the opening, and major axes of the plurality of openings have M orientations, where M is a positive integer greater than or equal to 2.

For example, for at least one sub-pixel, the opening and the light-emitting region are not concentric.

For example, a center offset between the opening and the light-emitting region is 1.5-2 µm.

For example, outward values of the same sub-pixel on opposite sides of the sub-pixel are different.

For example, the first sub-pixel is a red sub-pixel, the second sub-pixel is a green sub-pixel, and the third sub-pixel is a blue sub-pixel.

For example, the at least three sub-pixels include three sub-pixels having emission colors different from a central sub-pixel surrounded thereby.

For example, the at least three sub-pixels include at least one sub-pixel having an emission color the same as a central sub-pixel surrounded thereby.

For example, at least two sub-pixels emitting light of the same color have different outward values.

At least one embodiment of the present disclosure provides a display apparatus, including any one of the display panel as described above.

### BRIEF DESCRIPTION OF DRAWINGS

In order to clearly illustrate the technical solution of the embodiments of the present disclosure, the drawings of the embodiments will be briefly described in the following; it is obvious that the described drawings relate only to some embodiments of the present disclosure and are not intended to limit the present disclosure.
Fig. 1 is a cross-sectional view of a display panel.
Fig. 2 is a plan view of a display panel.
Fig. 3 is a plan view of a display panel provided by an embodiment of the present disclosure.
Fig. 4 is a plan view of a display panel provided by an embodiment of the present disclosure.
Fig. 5 is a diffraction intensity diagram of a display panel having an identical outward value.
Fig. 6 is a diffraction intensity diagram of a display panel having different outward values provided by an embodiment of the present disclosure.
Fig. 7 is a cross-sectional view of a display panel provided by an embodiment of the present disclosure.
Fig. 8 is a plan view of a display panel provided by an embodiment of the present disclosure.
Fig. 9 is a plan view of a display panel provided by an embodiment of the present disclosure.
Fig. 10 is a plan view of a display panel provided by an embodiment of the present disclosure.
Fig. 11 is a plan view of a display panel provided by an embodiment of the present disclosure.
Fig. 12 is a plan view of a display panel provided by an embodiment of the present disclosure.
Fig. 13 is a plan view of a display panel provided by an embodiment of the present disclosure.
Fig. 14 is a plan view of a display panel provided by an embodiment of the present disclosure.
Fig. 15 is a plan view of a sub-pixel in a display panel provided by an embodiment of the present disclosure.
Fig. 16 is a plan view of a sub-pixel in a display panel provided by an embodiment of the present disclosure.
Fig. 17 illustrates a forming process of an inverted elliptical shape provided by an embodiment of the present disclosure.

### DETAILED DESCRIPTION

In order to make objectives, technical details, and advantages of the embodiments of the present disclosure clearer, the technical solutions of the embodiments will be described in a clearly and fully understandable way with reference to the drawings related to the embodiments of the present disclosure. Apparently, the described embodiments are just a part but not all of the embodiments of the present disclosure. Based on the described embodiments herein, those skilled in the art can obtain other embodiment(s), without creative efforts, which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the present disclosure, are not intended to indicate any sequence, amount or importance, but distinguish various components. Also, similar words such as "a", "an", or "the" do not refer to a quantity limit, but refer to that there is at least one. The terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly. "On," "below," "right," "left" and the like are only used to indicate relative position relationship, and when the position of the described object is changed, the relative position relationship may be changed accordingly.

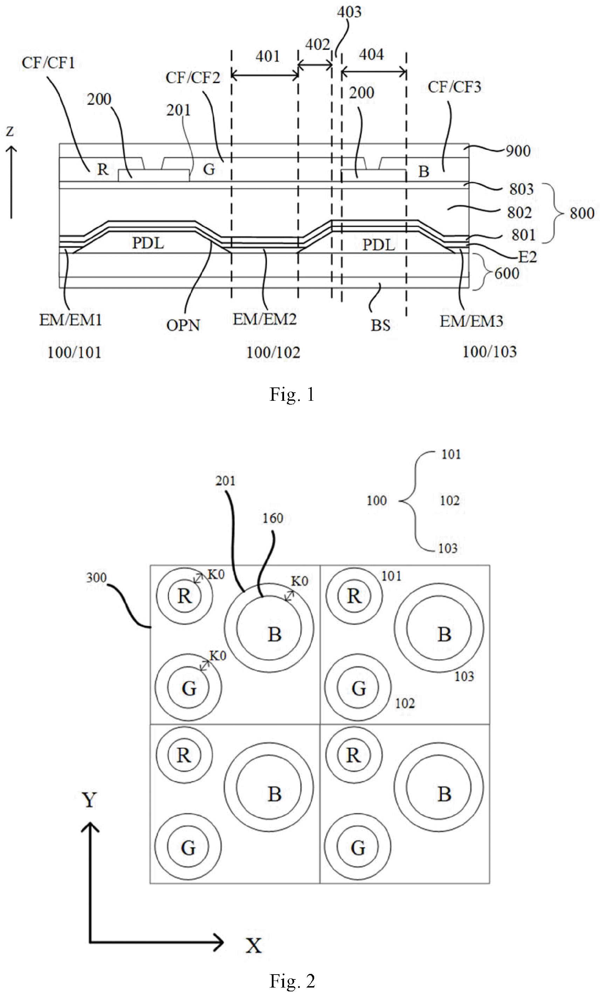

Fig. 1 is a cross-sectional view of a display panel. Fig. 2 is a plan view of a display panel. The display panel shown in Fig. 1 is a COE panel.

As shown in Figs. 1 and 2, the display panel includes a driving substrate 600 (including a base substrate BS). The driving substrate 600 includes a pixel circuit and a first electrode (for example, an anode of a light-emitting element) connected to the pixel circuit. A light-emitting functional layer EM and a second electrode E2 (for example, a cathode of the light-emitting element) are provided on the driving substrate 600. An encapsulation layer 800 is provided on the light-emitting element, and a black matrix 200 and a color filter layer CF are provided on the encapsulation layer 800. A cover layer 900 covers the black matrix 200 and the color filter layer CF. As shown in Fig. 1, the color filter layer CF includes a color filter portion CF1, a color filter portion CF2, and a color filter portion CF3. Fig. 1 illustrates an example in which the black matrix is provided as a separate structure. In other embodiments, the black matrix may alternatively be a color filter stack or include a color filter stack, as long as a light-shielding function can be achieved.

As shown in Figs. 1 and 2, the display panel includes a plurality of sub-pixels 100, each sub-pixel 100 including a light-emitting region 160. The light-emitting region 160 corresponds to an opening OPN of a pixel definition layer PDL and constitutes the active emitting area of the sub-pixel.

As shown in Figs. 1 and 2, the black matrix 200 includes a plurality of openings 201. For each sub-pixel 100, one opening 201 is arranged outside the corresponding light-emitting region 160. In the same sub-pixel 100, the distance between the opening 201 and the light-emitting region 160 is defined as an outward value K0, and the outward values K0 of the sub-pixels 100 are identical.

As shown in Fig. 2, the plurality of sub-pixels 100 include a first sub-pixel 101, a second sub-pixel 102, and a third sub-pixel 103, with each two of the first sub-pixel 101, the second sub-pixel 102, and the third sub-pixel 103 having different emission colors. As shown in Fig. 2, in a column of sub-pixels, several first sub-pixels 101 and several second sub-pixels 102 are alternately arranged along the direction Y. In an adjacent column, several third sub-pixels 103 are arranged along the direction Y. Between two columns of third sub-pixels 103, a column of sub-pixels with alternately arranged first sub-pixels 101 and second sub-pixels 102 along the direction Y is provided.

Fig. 2 illustrates that the display panel includes a plurality of repeating units 300. In the same repeating unit 300, the outward values K0 of all sub-pixels 100 are identical. The outward values K0 of all sub-pixels 100 are also identical in different repeating units 300.

For display panels in which the outward values K0 of all sub-pixels 100 are identical, significant diffraction problems are likely to occur.

Fig. 1 shows four regions: region 401, region 402, region 403, and region 404. The regions that primarily affect diffraction are these four regions. Region 401 corresponds to the light-emitting region, region 402 corresponds to the slope portion of the opening OPN in the pixel definition layer PDL, region 403 corresponds to the region between the top of the slope and the body of the black matrix 200, and region 404 corresponds to the region where the body of the black matrix 200 is located.

In order to mitigate diffraction and improve display quality, an embodiment of the present disclosure provides a display panel. The display panel provided by this embodiment can significantly mitigate diffraction in regions 401 and 402.

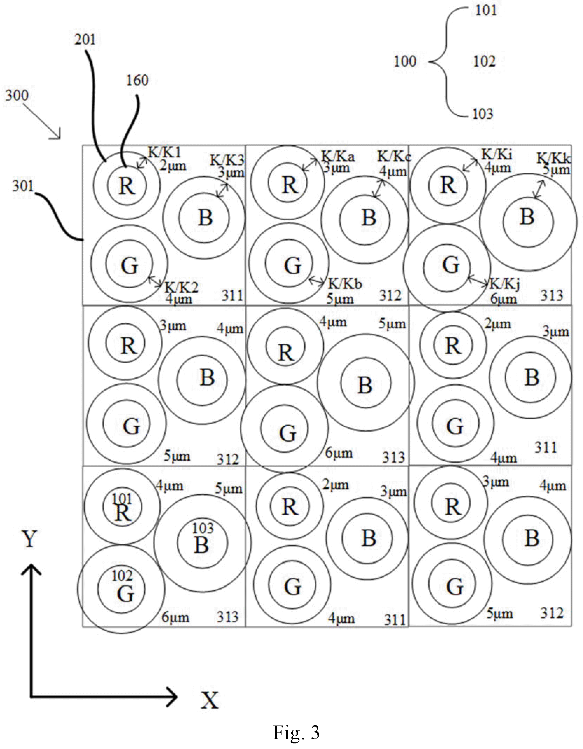

Fig. 3 is a plan view of a display panel provided by an embodiment of the present disclosure. As shown in Figs. 1 and 3, in the same sub-pixel 100, the distance between the orthographic projection of the opening 201 on the base substrate BS and the orthographic projection of the light-emitting region 160 on the base substrate BS is defined as an outward value K. Among the sub-pixels 100 adjacent to the same sub-pixel 100, the outward values K of at least three sub-pixels 100 are different from the outward value of the sub-pixel.

For example, in some embodiments, in the same sub-pixel 100, the distance between the orthographic projection of the opening 201 on the base substrate BS and the orthographic projection of the light-emitting region 160 on the base substrate BS is defined as an outward value K, and among the sub-pixels 100 adjacent to the same sub-pixel 100, the outward values K of at least two sub-pixels 100 are different from that of the sub-pixel.

An embodiment of the present disclosure provides a display panel in which among the sub-pixels 100 adjacent to the same sub-pixel 100, the outward values K of at least three sub-pixels 100 are different from the outward value of the sub-pixel, thereby effectively reducing diffraction and improving display quality. The display panel provided by this embodiment can effectively mitigate dark-state diffraction.

In the embodiments of the present disclosure, adjacent sub-pixels refer to sub-pixels that are directly adjacent, that is, no other sub-pixels are present between the adjacent sub-pixels. In other words, the line connecting the centers of two adjacent sub-pixels does not pass through any other sub-pixel. As shown in Fig. 3, the emission colors of the sub-pixels are labeled as R, G, and B. A sub-pixel labeled R has ten adjacent sub-pixels, a sub-pixel labeled G has ten adjacent sub-pixels, and a sub-pixel labeled B has ten adjacent sub-pixels. Of course, the emission colors of the sub-pixels are not limited to R, G, and B and can be set as needed.

Among the sub-pixels 100 adjacent to the same sub-pixel 100, at least three sub-pixels 100 having outward values K different from that of the sub-pixel means that, for a given central sub-pixel and several peripheral sub-pixels that surround and are adjacent to the given central sub-pixel, at least three peripheral sub-pixels have outward values K different from the outward value K of the central sub-pixel.

In the display panel provided by an embodiment of the present disclosure, the outward values K of the sub-pixels 100 can be arranged randomly to mitigate diffraction. Of course, other arrangements may also be used.

For example, for ease of fabrication, multiple sub-pixels 100 form multiple repeating units 300. Fig. 3 illustrates one repeating unit 300. The repeating units 300 may be arranged along the direction X and the direction Y to form an array.

As shown in Fig. 3, each repeating unit 300 includes at least one repeating sub-unit 301. Fig. 3 illustrates a total of nine repeating sub-units 301 arranged in three rows and three columns.

As shown in Fig. 3, in at least one repeating sub-unit 301, each repeating sub-unit 301 includes a first sub-pixel 101, a second sub-pixel 102, and a third sub-pixel 103, and the emission colors of each two of the first sub-pixel 101, second sub-pixel 102, and third sub-pixel 103 are different. In the display panel provided by the embodiment of the present disclosure, one repeating sub-unit 301 including three sub-pixels is used as an example for illustration, but not limited thereto, and a repeating sub-unit 301 may include other numbers of sub-pixels.

For example, as shown in Fig. 3, the outward values K of the first sub-pixel 101, second sub-pixel 102, and third sub-pixel 103 in the same repeating sub-unit 301 are different. Fig. 3 illustrates three different types of repeating sub-units 301. As shown in Fig. 3, the display panel includes a repeating sub-unit 311, a repeating sub-unit 312, and a repeating sub-unit 313, which are arranged in the manner of permutations and combinations.

For example, as shown in Fig. 3, in the first row of repeating sub-units, repeating sub-units 311, 312, and 313 are arranged sequentially; in the second row of repeating sub-units, repeating sub-units 312, 313, and 311 are arranged sequentially; in the third row of repeating sub-units, repeating sub-units 313, 311, and 312 are arranged sequentially. Similarly, the arrangement can be described along the column direction. As shown in Fig. 3, in the first column of repeating sub-units, repeating sub-units 311, 312, and 313 are arranged sequentially; in the second column of repeating sub-units, repeating sub-units 312, 313, and 311 are arranged sequentially; in the third column of repeating sub-units, repeating sub-units 313, 311, and 312 are arranged sequentially.

For example, identical repeating sub-units 301 have the same outward value K configuration for their sub-pixels.

As shown in Fig. 3, for the repeating sub-unit 311, the outward value K of the first sub-pixel 101 is K1, the outward value K of the second sub-pixel 102 is K2, and the outward value K of the third sub-pixel 103 is K3.

As shown in Fig. 3, for the repeating sub-unit 312, the outward value K of the first sub-pixel 101 is Ka, the outward value K of the second sub-pixel 102 is Kb, and the outward value K of the third sub-pixel 103 is Kc.

As shown in Fig. 3, for the repeating sub-unit 313, the outward value K of the first sub-pixel 101 is Ki, the outward value K of the second sub-pixel 102 is Kj, and the outward value K of the third sub-pixel 103 is Kk.

Tables 1 to 3 respectively provide the outward values K of the first sub-pixel 101, the second sub-pixel 102, and the third sub-pixel 103.

As can be seen from Fig. 3 and Tables 1 to 3, for sub-pixels emitting the same color, at least three sub-pixels adjacent to the same sub-pixel have different outward values K. For the first sub-pixel 101 at the central position in Table 1 (outward value K = 4 µm), there are three first sub-pixels 101 adjacent to the central first sub-pixel 101 having different outward values K. For the second sub-pixel 102 at the central position in Table 2, there are three second sub-pixels 102 with different outward values K. For the third sub-pixel 103 at the central position in Table 3, there are three third sub-pixels 103 with different outward values K. When the values in Tables 1 to 3 are slightly varied, more than three adjacent sub-pixels will have different outward values K.

**Table 1: Outward values K (µm) of the first sub-pixel 101 in the display panel shown in Fig. 3**

| | | |
|---|---|---|
| 2 | 3 | 4 |
| 3 | 4 | 2 |
| 4 | 2 | 3 |

**Table 2: Outward values K (µm) of the second sub-pixel 102 in the display panel shown in Fig. 3**

| | | |
|---|---|---|
| 4 | 5 | 6 |
| 5 | 6 | 4 |
| 6 | 4 | 5 |

**Table 3: Outward values K (µm) of the third sub-pixel 103 in the display panel shown in Fig. 3**

| | | |
|---|---|---|
| 3 | 4 | 5 |
| 4 | 5 | 3 |
| 5 | 3 | 4 |

For example, as shown in Fig. 3, each repeating unit 300 includes a plurality of repeating sub-units 301. To maximize the differentiation of outward values K, in at least three different repeating sub-units 301, the outward values K of the first sub-pixels 101 are different, the outward values K of the second sub-pixels 102 are different, and the outward values K of the third sub-pixels 103 are different. In each row of repeating sub-units 301 shown in Fig. 3, the outward values K of the first sub-pixels 101 are different, the outward values K of the second sub-pixels 102 are different, and the outward values K of the third sub-pixels 103 are different.

For example, as shown in Fig. 3, to maximize the differentiation of outward values K, along the arrangement direction of three different repeating sub-units 301, the outward values K of the first sub-pixels 101 increase sequentially, the outward values K of the second sub-pixels 102 increase sequentially, and the outward values K of the third sub-pixels 103 increase sequentially. In the first row and first column of repeating sub-units 301 shown in Fig. 3, the outward values K of the first sub-pixels 101 increase sequentially, the outward values K of the second sub-pixels 102 increase sequentially, and the outward values K of the third sub-pixels 103 increase sequentially.

As shown in Fig. 3 and Table 1, in the repeating units 300, the outward values K of the first sub-pixel 101 include 2 µm, 3 µm, and 4 µm.

As shown in Fig. 3 and Table 2, in the repeating units 300, the outward values K of the second sub-pixel 102 include 4 µm, 5 µm, and 6 µm.

As shown in Fig. 3 and Table 3, in the repeating units 300, the outward values K of the third sub-pixel 103 include 3 µm, 4 µm, and 5 µm.

For example, in some embodiments, as shown in Fig. 3, among the sub-pixels 100 adjacent to the same sub-pixel 100, at least three sub-pixels 100 have outward values K different from that of the sub-pixel, and these at least three sub-pixels include three sub-pixels with emission colors different from that of the central sub-pixel they surround. That is, at least three of these sub-pixels have emission colors different from that of the central sub-pixel. In other words, at least three peripheral sub-pixels emitting light of colors different from the central sub-pixel have outward values K different from that of the central sub-pixel. Taking the third sub-pixel 103 in the central repeating sub-unit 313 shown in Fig. 3 as an example (as the central sub-pixel, located in the repeating sub-unit at the second row and second column), among the four second sub-pixels 102 at a periphery of the central sub-pixel, three second sub-pixels 102 have outward values different from that of the central sub-pixel, and among the four first sub-pixels 101 at a periphery of the central sub-pixel, all four first sub-pixels 101 have outward values different from that of the central sub-pixel.

For example, in some embodiments, as shown in Fig. 3, among the sub-pixels 100 adjacent to the same sub-pixel 100, at least three sub-pixels 100 have outward values K different from that of the sub-pixel, and at least one of these at least three sub-pixels 100 has the same emission color as the sub-pixel. In other words, at least one periphery sub-pixel emitting the same color as the central sub-pixel has an outward value different from that of the central sub-pixel. That is, the at least three sub-pixels include at least one sub-pixel with the same emission color as the central sub-pixel they surround. Taking the third sub-pixel 103 in the central repeating sub-unit 313 shown in Fig. 3 as an example (as the central sub-pixel, located in the repeating sub-unit at the second row and second column), the third sub-pixel 103 above it and the third sub-pixel 103 below it have outward values different from that of the central sub-pixel.

For example, in some embodiments, as shown in Fig. 3, among the sub-pixels emitting light of the same color, at least two sub-pixels have different outward values. Further, for example, among the sub-pixels emitting light of the same color, at least three sub-pixels have different outward values. As shown in Fig. 3, the first sub-pixels 101 have three outward values, which are 2 µm, 3 µm, and 4 µm, respectively. As shown in Fig. 3, the second sub-pixels 102 have three outward values, which are 4 µm, 5 µm, and 6 µm, respectively. As shown in Fig. 3, the outward values K of the third sub-pixels 103 include 3 µm, 4 µm, and 5 µm.

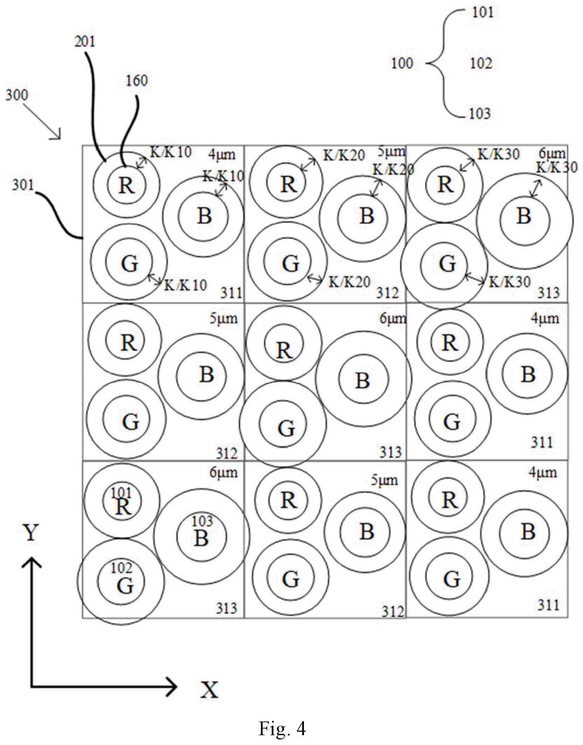

Fig. 4 is a plan view of a display panel provided by an embodiment of the present disclosure. As shown in Fig. 4, in the same sub-pixel 100, the distance between the orthographic projection of the opening 201 on the base substrate BS and the orthographic projection of the light-emitting region 160 on the base substrate BS is defined as an outward value K. Among the sub-pixels 100 adjacent to the same sub-pixel 100, the outward values K of at least three sub-pixels 100 are different from the outward value of the sub-pixel, so as to effectively mitigate diffraction and improve display quality.

**Table 4: Outward values K (µm) of the first sub-pixel 101/second sub-pixel 102/third sub-pixel 103 in the display panel shown in Fig. 4**

| | | |
|---|---|---|
| 4 | 5 | 6 |
| 5 | 6 | 4 |
| 6 | 5 | 4 |

For example, as shown in Fig. 4 and Table 4, the sub-pixels 100 in the same repeating sub-unit 301 have the same outward value K, and the outward values K of at least three different repeating sub-units 301 are different. A differentiation design of outward values is performed using the repeating sub-unit 301 as a basic unit for outward value variation. As shown in Fig. 4, the outward value K of the repeating sub-unit 311 is K10, the outward value K of the repeating sub-unit 312 is K20, and the outward value K of the repeating sub-unit 313 is K30. In the example of Fig. 4, K10 = 4 µm, K20 = 5 µm, and K30 = 6 µm.

For example, as shown in Fig. 4 and Table 4, each repeating unit 300 includes six repeating sub-units 301, and the six repeating sub-units 301 form a matrix of three rows and three columns. In the matrix, in a row direction, in at least one row of repeating sub-units 301, the outward values K of the three repeating sub-units 301 are different from one another. Accordingly, within the same repeating unit 300, in at least one row of repeating sub-units 301, a maximized differentiated design of outward values is achieved.

For example, as shown in Fig. 4 and Table 4, in a column direction, in at least one column of repeating sub-units 301, the outward values K of at least two different repeating sub-units 301 are different. Accordingly, a differentiated design of outward values is achieved in at least one column of repeating sub-units 301.

For example, as shown in Fig. 4 and Table 4, in order to achieve a differentiated design of outward values, in the row direction, in each of the three rows of repeating sub-units 301, the outward values K of the three repeating sub-units 301 are different from one another; and in the column direction, in each of the three columns of repeating sub-units 301, the outward values K of at least two different repeating sub-units 301 are different.

For example, as shown in Fig. 4 and Table 4, in the column direction, in one column of the three columns of repeating sub-units 301, the outward values K of three different repeating sub-units 301 are different from one another.

Tables 5 to 8 show the outward values K of multiple repeating sub-units 301 in one repeating unit 300. Similar to the case shown in Fig. 4, the outward values K within the same repeating sub-unit 301 are identical. That is, in the same repeating sub-unit 301, the outward values K of the first sub-pixel 101, the second sub-pixel 102, and the third sub-pixel 103 are the same.

As shown in Fig. 4 and Tables 5 to 8, in order to mitigate diffraction and improve display quality, among the sub-pixels 100 adjacent to the same sub-pixel 100, at least three sub-pixels 100 have outward values K different from that of the sub-pixel.

As shown in Fig. 4 and Tables 5 to 8, in order to mitigate diffraction and improve display quality, among repeating sub-units 301 adjacent to the same repeating sub-unit 301, the outward values K of at least three repeating sub-units 301 are different. For example, among the repeating sub-units 301 adjacent to the same repeating sub-unit 301, the outward values K of at least six repeating sub-units 301 are different from that of the repeating sub-unit 301.

**Table 5: Outward values K (µm) of repeating sub-units in repeating units of a display panel provided by an embodiment of the present disclosure**

| | | |
|---|---|---|
| 4 | 5 | 6 |
| 5 | 6 | 4 |
| 6 | 4 | 5 |

**Table 6: Outward values K (µm) of repeating sub-units in repeating units of a display panel provided by an embodiment of the present disclosure**

| | | | |
|---|---|---|---|
| 3 | 4 | 5 | 6 |
| 4 | 5 | 6 | 3 |
| 5 | 6 | 3 | 4 |
| 6 | 3 | 4 | 5 |

**Table 7: Outward values K (µm) of repeating sub-units in repeating units of a display panel provided by an embodiment of the present disclosure**

| | | | | |
|---|---|---|---|---|
| 2 | 3 | 4 | 5 | 6 |
| 3 | 4 | 5 | 6 | 2 |
| 4 | 5 | 6 | 2 | 3 |
| 5 | 6 | 2 | 3 | 4 |
| 6 | 2 | 3 | 4 | 5 |

**Table 8: Outward values K (µm) of repeating sub-units in repeating units of a display panel provided by an embodiment of the present disclosure**

| | | | | | |
|---|---|---|---|---|---|
| 2 | 3 | 4 | 5 | 6 | ... |
| 3 | 4 | 5 | 6 | 2 | ... |
| 4 | 5 | 6 | 2 | 3 | ... |
| 5 | 6 | 2 | 3 | 4 | ... |
| 6 | 2 | 3 | 4 | 5 | ... |
| ... | ... | ... | ... | ... | ... |

Tables 9 to 12 show the outward values K of multiple repeating sub-units 301 in one repeating unit 300. Similar to the case shown in Fig. 4, the outward values K within the same repeating sub-unit 301 are identical. That is, in the same repeating sub-unit 301, the outward values K of the first sub-pixel 101, the second sub-pixel 102, and the third sub-pixel 103 are the same.

In the display panels shown in Tables 9 to 12, a pixel arrangement as shown in Fig. 4 is adopted. As shown in Tables 9 to 12, the outward values K of different repeating sub-units 301 are randomly arranged. Within the same repeating unit 300, more than two outward values K are present, such that among sub-pixels adjacent to the same sub-pixel, at least three sub-pixels have outward values different from that of the sub-pixel. For example, the outward values K may be randomly arranged and may follow the rules of permutations and combinations.

The minimum gap between different outward values among multiple outward values is denoted as GAP.

**Table 9: Outward values K (µm) and minimum gap GAP (GAP = 3 µm) of repeating sub-units in repeating units of a display panel provided by an embodiment of the present disclosure**

| | |
|---|---|
| 2 | 5 |
| 5 | 2 |

**Table 10: Outward values K (µm) and minimum gap GAP (GAP = 0.5 µm) of repeating sub-units in repeating units of a display panel provided by an embodiment of the present disclosure**

| | | |
|---|---|---|
| 4 | 4.5 | 5 |
| 4.5 | 5 | 4 |
| 5 | 4 | 4.5 |

**Table 11: Outward values K (µm) and minimum gap GAP (GAP = 2 µm) of repeating sub-units in repeating units of a display panel provided by an embodiment of the present disclosure**

| | | |
|---|---|---|
| 2 | 4 | 6 |
| 4 | 6 | 2 |
| 6 | 2 | 4 |

**Table 12: Outward values K (µm) and minimum gap GAP (GAP = 2 µm) of repeating sub-units in repeating units of a display panel provided by an embodiment of the present disclosure**

| | | |
|---|---|---|
| 1 | 3 | 5 |
| 3 | 5 | 1 |
| 5 | 1 | 3 |

For example, as can be seen from Fig. 3, Fig. 4, and the corresponding tables, the outward value K is greater than or equal to 1 µm. In the display panels shown in Fig. 3 and Fig. 4, the outward value K is greater than or equal to 1 µm. Further, in some examples, in the display panels shown in Fig. 3 and Fig. 4, the outward value K is greater than or equal to 2 µm. The larger the outward value K, the more beneficial it is to mitigate diffraction.

For example, as can be seen from Fig. 3, Fig. 4, and the corresponding tables, the minimum gap between different outward values among multiple outward values K is greater than or equal to 0.5 µm. The display panels shown in Fig. 3 and Fig. 4 take the minimum gap of 1 µm between different outward values among the plurality of outward values K as an example. Further, for example, in order to mitigate diffraction, the minimum gap between different outward values among the plurality of outward values K is greater than or equal to 0.8 µm.

For example, as can be seen from Fig. 3, Fig. 4, and the corresponding tables, the outward value K is less than or equal to 4 µm. For example, in some embodiments, the outward value K is greater than or equal to 1 µm and less than or equal to 4 µm.

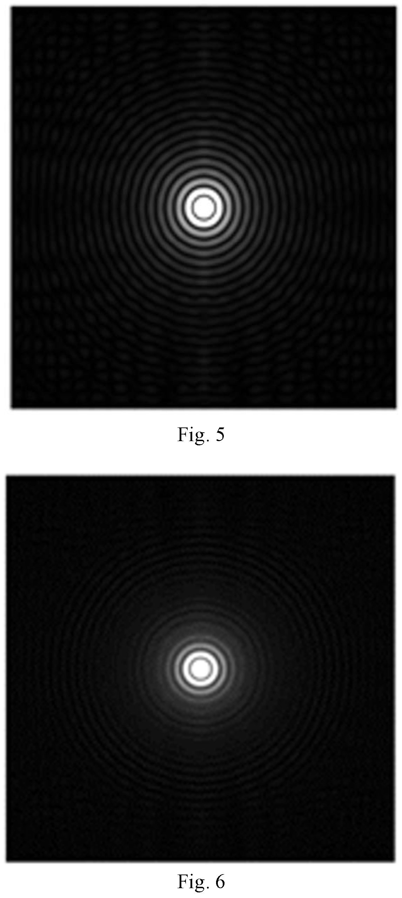

Fig. 5 is a diffraction intensity diagram of a display panel having an identical outward value K (K = 5 µm). Fig. 6 is a diffraction intensity diagram of a display panel having different outward values K provided by an embodiment of the present disclosure. As can be seen from Figs. 5 and 6, the embodiments of the present disclosure effectively mitigate diffraction by providing different outward values K.

In the display panels provided by the embodiments of the present disclosure, a larger outward value K results in a larger diffraction aperture and wider spacing between diffraction fringes. By configuring the display panel to have different outward values K, diffraction can be effectively reduced. In addition, an increase in the outward value K can also improve color shift and alleviate luminance decay (L-decay).

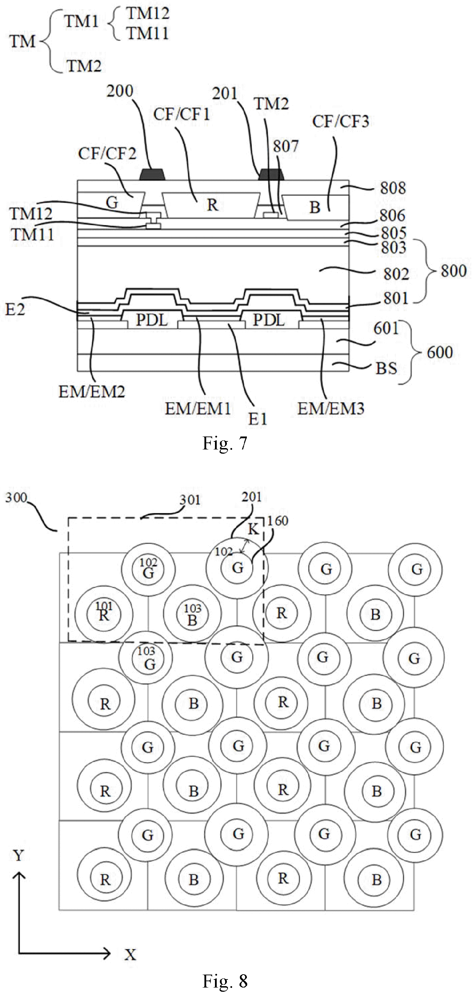

Fig. 7 is a cross-sectional view of a display panel provided by an embodiment of the present disclosure. For example, as shown in Fig. 7, the display panel further includes a color filter layer CF, and an insulating layer 808 is disposed between the color filter layer CF and a black matrix 200. The insulating layer 808 functions to space apart the color filter layer CF and the black matrix 200. By disposing the insulating layer 808 between the color filter layer CF and the black matrix 200, overlap between the color filter layer CF and the black matrix 200 can be reduced. Accordingly, the outward value K is not affected by the overlap between the color filter layer CF and the black matrix 200, which is beneficial to increasing the outward value K. For example, the outward value K is not affected by the overlap between the color filter layer CF and the black matrix 200 such as about 4.5 µm, the outward value K can be increased. For example, an upper limit of the outward value K can be increased to 8.5 µm, such that the outward value K is less than or equal to 8.5 µm. Such a configuration in which the insulating layer 808 is disposed between the color filter layer CF and the black matrix 200 provides ample space for random arrangement of the outward value K.

For example, as shown in Fig. 7, the display panel includes a base substrate BS. The color filter layer CF is closer to the base substrate BS than the black matrix 200, and the insulating layer 808 covers the color filter layer CF.

For example, the insulating layer 808 may be made of an insulating material. For example, the insulating layer 808 may be made of an organic insulating material and/or an inorganic insulating material.

Fig. 7 illustrates a driving substrate 600. As shown in Fig. 7, the driving substrate 600 includes a base substrate BS and a driving circuit layer 601 located on the base substrate BS. For example, the driving circuit layer 601 includes a plurality of transistors and a plurality of capacitors.

As shown in Fig. 7, a plurality of first electrodes E1 that are separated from each other are disposed on the driving circuit layer 601. A pixel definition layer PDL is disposed on the plurality of first electrodes E1. The pixel definition layer PDL includes a plurality of pixel openings OPN, and each of the plurality of pixel openings OPN is configured to expose at least a portion of the first electrodes E1 so as to define a light-emitting region. A light-emitting functional layer EM is disposed on the plurality of first electrodes E1, a second electrode E2 is disposed on the light-emitting functional layer EM, an encapsulation layer 800 is disposed on the second electrode E2, a buffer layer 805 is disposed on the encapsulation layer 800, a touch structure TM is disposed on the buffer layer 805, and an insulating layer 807 is disposed on the touch structure TM. As shown in Fig. 7, the touch structure TM includes a first touch line TM1 and a second touch line TM2. The first touch line TM1 includes a first touch portion TM11 and a second touch portion TM12, and an interlayer insulating layer 806 is disposed between the first touch portion TM11 and the second touch portion TM12. A color filter layer CF is disposed on the interlayer insulating layer 806, an insulating layer 808 is disposed on the color filter layer CF, and a black matrix 200 is disposed on the insulating layer 808. The color filter layer CF and the light-emitting functional layer EM are as described above and will not be repeated herein.

As shown in Fig. 7, the insulating layer 807 covers the touch structure TM to provide a protective function. The structure of the touch structure TM is not limited to that shown in the figure.

As shown in Fig. 7, the height of the insulating layer 807 is less than that of the color filter layer CF. The top surface of the insulating layer 807 is closer to the base substrate than the top surface of the color filter layer CF.

For example, the first electrode E1, the second electrode E2, and the light-emitting functional layer EM disposed between them together form a light-emitting element.

For example, the first electrode E1 serves as an anode, and the second electrode E2 serves as a cathode.

Fig. 8 is a plan view of a display panel provided by an embodiment of the present disclosure. As shown in Fig. 8, the repeating unit 300 includes a plurality of repeating sub-units 301. Each repeating sub-unit 301 includes one first sub-pixel 101, two second sub-pixels 102, and one third sub-pixel 103, and the emission colors of each two of the first sub-pixel 101, the second sub-pixels 102, and the third sub-pixel 103 are different. As shown in Fig. 8, the repeating sub-units 301 are arranged in an array along the direction X and the direction Y. In the display panels shown in Figs. 3 and 4, each repeating sub-unit 301 includes one first sub-pixel 101, one second sub-pixel 102, and one third sub-pixel 103.

For example, as shown in Fig. 8, the light-emitting region 160 of a sub-pixel has a circular shape, and the opening 201 of the black matrix also has a circular shape. In some sub-pixels, the opening 201 of the black matrix is concentric with the light-emitting region 160. In other sub-pixels, the opening 201 of the black matrix is non-concentric with the light-emitting region 160; that is, the centers of the opening 201 of the black matrix and the light-emitting region 160 do not coincide and there is a certain distance between them. Of course, the light-emitting region 160 of at least one sub-pixel shown in Fig. 8 may also have a non-circular shape, such as an inverted elliptical shape, and at least one opening 201 of the black matrix may also have a non-circular shape, such as an inverted elliptical shape. For example, the shapes of the light-emitting region of a sub-pixel and at least one opening 201 of the black matrix may also be polygonal, elliptical, or other shapes, which is not limited in the present application.

As shown in Fig. 8, the plurality of sub-pixels 100 include a first sub-pixel 101, a second sub-pixel 102, and a third sub-pixel 103, and each two of the first sub-pixel 101, the second sub-pixel 102, and the third sub-pixel 103 have different light-emitting colors. As shown in Fig. 8, in one row of sub-pixels, a plurality of first sub-pixels 101 and a plurality of third sub-pixels 103 are alternately arranged along the direction X, and in another adjacent row of sub-pixels, a plurality of second sub-pixels 102 are arranged along the direction X. A sub-pixel column in which a plurality of first sub-pixels 101 and a plurality of third sub-pixels 103 are alternately arranged is provided between two rows of second sub-pixels.

Tables 13 to 15 show conditions of the outward value K of the sub-pixels in the pixel arrangement shown in Fig. 8.

**Table 13: Outward values K (µm) of the sub-pixels in the display panel shown in Fig. 8**

| | | | | | | | | | | |
|---|---|---|---|---|---|---|---|---|---|---|
| | 4 | | 5 | | 6 | | 4 | | 5 | |
| 4 (R) | | 4 (B) | | 5 (R) | | 5 (B) | | 6 (R) | | 6 (B) |
| | 5 | | 6 | | 4 | | 5 | | 6 | |
| 4 (R) | | 5 (B) | | 6 (R) | | 6 (B) | | 4 (R) | | 4 (B) |
| | 6 | | 4 | | 5 | | 6 | | 4 | |
| 6 (R) | | 6 (B) | | 4 (R) | | 4 (B) | | 5 (R) | | 5 (B) |
| | 4 | | 5 | | 6 | | 4 | | 5 | |
| 4 (R) | | 4 (B) | | 5 (R) | | 5 (B) | | 6 (R) | | 6 (B) |

**Table 14: Outward values K (µm) of the sub-pixels in the display panel with the pixel arrangement shown in Fig. 8**

| | | | | | | | | | | |
|---|---|---|---|---|---|---|---|---|---|---|
| | 4 | | 5 | | 6 | | 4 | | 5 | |
| 4 (R) | | 4 (B) | | 5 (R) | | 5 (B) | | 6 (R) | | 6 (B) |
| | 5 | | 6 | | 4 | | 5 | | 6 | |
| 5 (R) | | 5 (B) | | 6 (R) | | 6 (B) | | 4 (R) | | 4 (B) |
| | 6 | | 4 | | 5 | | 6 | | 4 | |
| 6 (R) | | 6 (B) | | 4 (R) | | 4 (B) | | 5 (R) | | 5 (B) |
| | 4 | | 5 | | 6 | | 4 | | 5 | |
| 4 (R) | | 4 (B) | | 5 (R) | | 5 (B) | | 6 (R) | | 6 (B) |

**Table 15: Outward values K (µm) of the sub-pixels in the display panel with the pixel arrangement shown in Fig. 8**

| | | | | | | | | | | | |
|---|---|---|---|---|---|---|---|---|---|---|---|
| | 4 | | 4 | | 5 | | 5 | | 6 | | 6 |
| 4 (R) | | 4 (B) | | 5 (R) | | 5 (B) | | 6 (R) | | 6 (B) | |
| | 4 | | 4 | | 5 | | 5 | | 6 | | 6 |
| 5 (R) | | 5 (B) | | 6 (R) | | 6 (B) | | 4 (R) | | 4 (B) | |
| | 5 | | 5 | | 6 | | 6 | | 4 | | 4 |
| 6 (R) | | 6 (B) | | 4 (R) | | 4 (B) | | 5 (R) | | 5 (B) | |
| | 5 | | 5 | | 6 | | 6 | | 4 | | 4 |
| 4 (R) | | 4 (B) | | 5 (R) | | 5 (B) | | 6 (R) | | 6 (B) | |
| | 6 | | 6 | | 4 | | 4 | | 5 | | 5 |
| 4 (R) | | 4 (B) | | 5 (R) | | 5 (B) | | 6 (R) | | 6 (B) | |
| | 6 | | 6 | | 4 | | 4 | | 5 | | 5 |

In Tables 13 to 15, numerals without any label indicate green sub-pixels (second sub-pixels 102), numerals labeled with "R" indicate red sub-pixels (first sub-pixels 101), and numerals labeled with "B" indicate blue sub-pixels (third sub-pixels 103).

It can be seen from Tables 13 to 15 that, among sub-pixels 100 adjacent to the same sub-pixel 100, outward values K of at least three sub-pixels 100 are different from the outward value of the sub-pixel, so as to effectively mitigate diffraction and improve display quality.

For the display panel having the pixel arrangement shown in Fig. 8, as shown in Table 15, for green sub-pixels, the outward values of adjacent two rows of sub-pixels may be set to have the same arrangement. As shown in Table 15, two green sub-pixels (second sub-pixels 102) in the same repeating sub-unit have the same outward value.

Table 16 shows a pixel arrangement in a display panel provided by an embodiment of the present disclosure. Under this pixel arrangement, two rows and four columns of a total of eight sub-pixels form one repeating sub-unit, where one row is arranged as RGBG and the row below is arranged as BGRG. Based on the repeating sub-unit, a 2×2 array, a 4×4 array, an 8×8 array, or a 16×16 array may be formed. The outward values of the sub-pixels in each array may be randomly arranged. For example, the outward value K may range from 1.5 µm to 5 µm, and a minimum gap between different outward values K may be 0.5 µm. Table 16 corresponds to a 4×3 array. Table 17 corresponds to a 2×2 array. Table 17 includes 8 R, 8 B, and 16 G, with the minimum gap being 0.5 µm. If the outward values K are increased sequentially based on the minimum gap, the minimum gap GAP may be calculated by subtracting a minimum value of the outward value K from a maximum value of the outward value K and then dividing the result by the number of R or B minus one, that is, minimum gap GAP = (amax - amin) / (N - 1), where N is the number of R or B, amax is a maximum value of the outward value K, and amin is a minimum value of the outward value K.

Table 17 shows outward values of sub-pixels in the display panel having the pixel arrangement shown in Table 16. It can be seen from Table 17 that, among sub-pixels 100 adjacent to the same sub-pixel 100, outward values K of at least three sub-pixels 100 are different from the outward value of the sub-pixel. By differentiating the outward values of sub-pixels of different colors, diffraction can be effectively reduced and display quality can be improved.

**Table 16: Pixel arrangement in a display panel provided by an embodiment of the present disclosure**

| | | | | | | | | | | | |
|---|---|---|---|---|---|---|---|---|---|---|---|
| R | G | B | G | R | G | B | G | R | G | B | G |
| B | G | R | G | B | G | R | G | B | G | R | G |
| R | G | B | G | R | G | B | G | R | G | B | G |
| B | G | R | G | B | G | R | G | B | G | R | G |
| R | G | B | G | R | G | B | G | R | G | B | G |
| B | G | R | G | B | G | R | G | B | G | R | G |
| R | G | B | G | R | G | B | G | R | G | B | G |
| B | G | R | G | B | G | R | G | B | G | R | G |

**Table 17: Outward values (µm) of the sub-pixels in the display panel with the pixel arrangement shown in Table 16**

| | | | | | | | |
|---|---|---|---|---|---|---|---|
| 1.5 (R) | 4 | 5 (B) | 4.5 | 2.5 (R) | 1.5 | 2 (B) | 4.5 |
| 1.5 (B) | 3.5 | 2 (R) | 1.5 | 2.5 (B) | 2 | 3 (R) | 3 |
| 3.5 (R) | 2.5 | 4 (B) | 2.5 | 4.5 (R) | 5 | 3 (B) | 2 |
| 4.5 (B) | 3.5 | 4 (R) | 3 | 3.5 (B) | 4 | 5 (R) | 2 |

Table 18 shows outward values of sub-pixels in the display panel having the pixel arrangement shown in Table 16. As shown in Table 18, the sub-pixels are arranged in an array, and the outward values K of the sub-pixels are randomly distributed, such that a 4×4 array, a 6×6 array, or an 8×8 array may be formed. Of course, other arrays may also be formed.

As shown in Table 18, the outward values K of the sub-pixels sequentially increase from small to large as 1.5, 1.7, 1.9, 2.1, 2.3, 2.5, 2.7, 2.9, 3.1, 3.3, 3.5, 3.7, 3.9, 4.1, 4.3, 4.5, 4.7, and 4.9, such that a minimum gap between different outward values K is 0.2 µm.

**Table 18: Outward values (µm) of the sub-pixels in the display panel with the pixel arrangement shown in Table 16**

| | | | | | | | | | | | |
|---|---|---|---|---|---|---|---|---|---|---|---|
| 1.9 (R) | 4.9 | 4.9 (B) | 2.9 | 3.1 (R) | 3.7 | 2.9 (B) | 4.1 | 2.9 (R) | 4.5 | 4.1 (B) | 1.9 |
| 2.7 (B) | 3.9 | 2.3 (R) | 4.5 | 2.1 (B) | 2.5 | 3.5 (R) | 4.7 | 3.9 (B) | 3.3 | 4.7 (R) | 2.1 |
| 3.9 (R) | 3.5 | 4.3 (B) | 2.3 | 1.5 (R) | 3.9 | 3.3 (B) | 3.1 | 2.1 (R) | 2.5 | 2.3 (B) | 1.7 |
| 3.5 (B) | 4.3 | 4.3 (R) | 3.5 | 3.7 (B) | 2.1 | 2.7 (R) | 4.3 | 2.5 (B) | 2.7 | 3.7 (R) | 1.9 |
| 2.5 (R) | 3.7 | 3.1 (B) | 4.7 | 4.1 (R) | 3.3 | 1.7 (B) | 2.5 | 1.7 (R) | 4.9 | 4.5 (B) | 2.3 |
| 1.9 (B) | 4.1 | 3.3 (R) | 2.7 | 4.7 (B) | 2.9 | 4.5 (R) | 3.1 | 1.5 (B) | 2.1 | 4.9 (R) | 1.7 |

Table 19 shows outward values of sub-pixels in the display panel having the pixel arrangement shown in Table 16. As shown in Table 19, the sub-pixels are arranged in an array, and the number of sub-pixels in a repeating sub-unit is an integer multiple of the minimum gap between different outward values K. As shown in Table 19, the outward values K range from 2.5 µm to 5 µm, and the minimum gap between different outward values K is 0.5 µm. Each color of sub-pixels may have six values (outward values K), that is, six values per cycle. With three colors, there are 18 sub-pixels, which may be cycled three times. What is shown in Table 19 constitutes one repeating unit.

For example, in some other embodiments, based on the pixel arrangement shown in Table 17, the outward values K range from 1.5 µm to 5 µm, and the minimum gap between different outward values K is 0.5 µm. Eight values constitute one cycle, with a total of 32 pixels, which may be cycled four times. That is, the repeating unit is a 2×2 array.

**Table 19: Outward values (µm) of the sub-pixels in the display panel with the pixel arrangement shown in Table 16**

| | | | | | | | | | | | |
|---|---|---|---|---|---|---|---|---|---|---|---|
| 4.5 (R) | 2.5 | 4 (B) | 5 | 4 (R) | 3 | 2.5 (B) | 2.5 | 4.5 (R) | 5 | 3 (B) | 3 |
| 3.5 (B) | 3 | 3.5 (R) | 4 | 3.5 (B) | 3.5 | 3 (R) | 4 | 4 (B) | 4 | 3 (R) | 3.5 |
| 3 (R) | 3.5 | 2.5 (B) | 3.5 | 2.5 (R) | 4 | 3 (B) | 3.5 | 5 (R) | 3.5 | 2.5 (B) | 4 |
| 4.5 (B) | 4 | 3.5 (R) | 2.5 | 4 (B) | 2.5 | 3.5 (R) | 3 | 5 (B) | 2.5 | 3.5 (R) | 2.5 |
| 2.5 (R) | 4.5 | 3 (B) | 3 | 5 (R) | 4.5 | 4.5 (B) | 4.5 | 2.5 (R) | 3 | 5 (B) | 4.5 |
| 5 (B) | 5 | 4 (R) | 4.5 | 4.5 (B) | 5 | 4 (R) | 5 | 3.5 (B) | 4.5 | 4.5 (R) | 5 |

In Tables 17 and 19, numerals without any label indicate green sub-pixels (second sub-pixels 102), numerals labeled with "R" indicate red sub-pixels (first sub-pixels 101), and numerals labeled with "B" indicate blue sub-pixels (third sub-pixels 103).

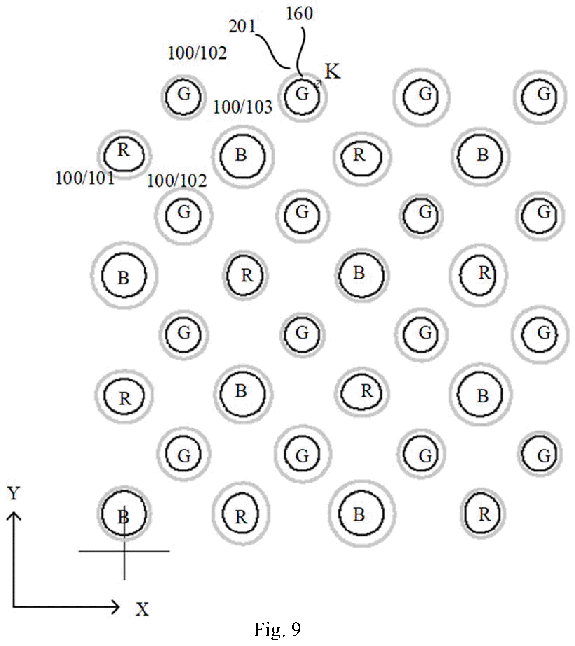

Fig. 9 is a plan view of a display panel provided by an embodiment of the present disclosure. The outward values K in the display panel shown in Fig. 9 may be randomly arranged. As shown in Fig. 9, light-emitting regions 160 of some sub-pixels are non-circular in shape. For example, the non-circular shape includes an elliptical shape or an inverted elliptical shape, but is not limited thereto.

For example, as shown in Fig. 9, at least one opening 201 among the plurality of openings 201 is non-circular in shape. The opening 201 of the black matrix has a major axis A1, and a dimension of the opening 201 in an extending direction of the major axis A1 is a maximum dimension of the opening 201. The major axes A1 of the openings 201 have M orientations, where M is a positive integer greater than or equal to 2.

The orientations described above refer to directions in which the extending direction of the major axis A1 points in space. For example, directions X and Y in the display panel may be taken as references, and different orientations refer to different included angles with respect to the direction X or the direction Y.

In the display panel provided by the embodiment of the present disclosure, by configuring the major axes A1 to have M orientations, multiple openings of the black matrix can have different orientations, which can disrupt stable interference among sub-pixels. The above configuration allows diffraction patterns to be different from one another. When the diffraction patterns are superimposed, they can be blurred while experiencing less constructive interference (i.e., the color separation apertures are blurred). Becuase the major axes A1 of multiple openings of the black matrix include M orientations, they may be arranged at various angles, causing the directions of the diffraction patterns to change. As a result, the diffraction patterns mix and blur with each other, leading to a scattering effect, reducing diffraction, and improving display quality.

Referring to Fig. 9, the pixel arrangement of the display panel is as follows. In one column of sub-pixels, a plurality of first sub-pixels 101 and a plurality of third sub-pixels 103 are alternately arranged along the direction Y, and in an adjacent column of sub-pixels, a plurality of second sub-pixels 102 are arranged along the direction Y. Between two columns of second sub-pixels, a column of sub-pixels in which a plurality of first sub-pixels 101 and a plurality of third sub-pixels 103 are alternately arranged is provided.

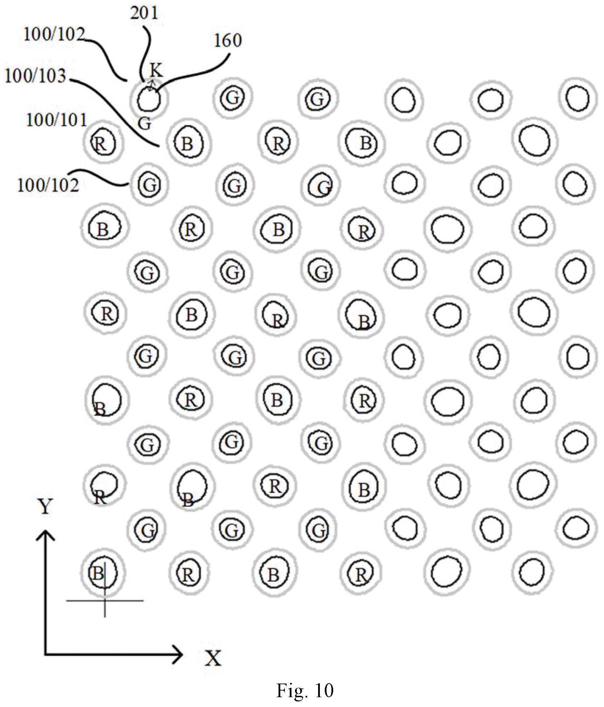

Fig. 10 is a plan view of a display panel provided by an embodiment of the present disclosure. In some embodiments, as shown in Fig. 10, the outward values K of the sub-pixels may be identical to one another, while the major axes A1 of the openings 201 have M orientations. Of course, the two approaches may also be combined, that is, the outward values K of the sub-pixels may be different, and the major aexs A1 of the openings 201 may have M orientations. The differing outward values K may be implemented using any of the methods described above. For example, the outward values K may range from 2 µm to 5 µm, but are not limited thereto. In one embodiment, the outward value K is 5 µm.

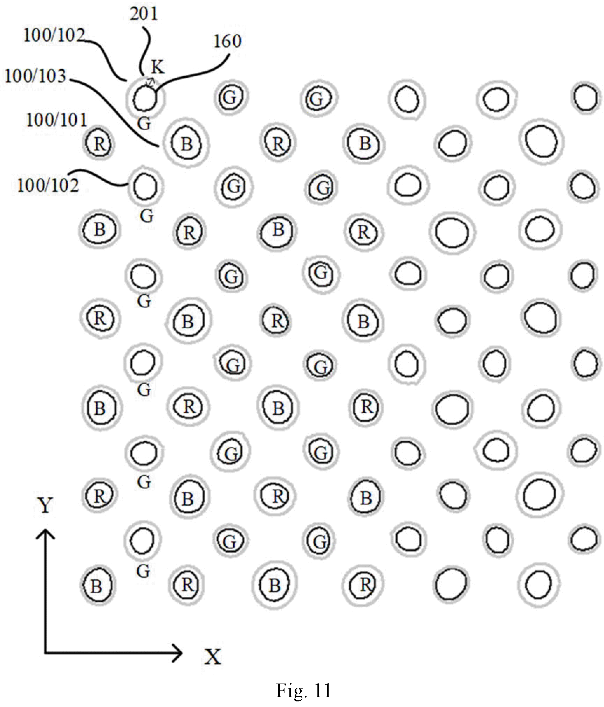

Fig. 11 is a plan view of a display panel provided by an embodiment of the present disclosure. In Fig. 11, the major axes A1 of the openings 201 have M orientations, where M is a positive integer greater than or equal to 2. For example, in one repeating unit, there are a total of 18 sub-pixels consisting of first sub-pixels 101 (R) and third sub-pixels 103 (B), and 36 second sub-pixels 102 (G). The rotation interval can be calculated as 360° divided by 18, resulting in an interval of 20°. Of course, repeating units with other numbers of sub-pixels may also be used, and other rotation schemes may also be employed.

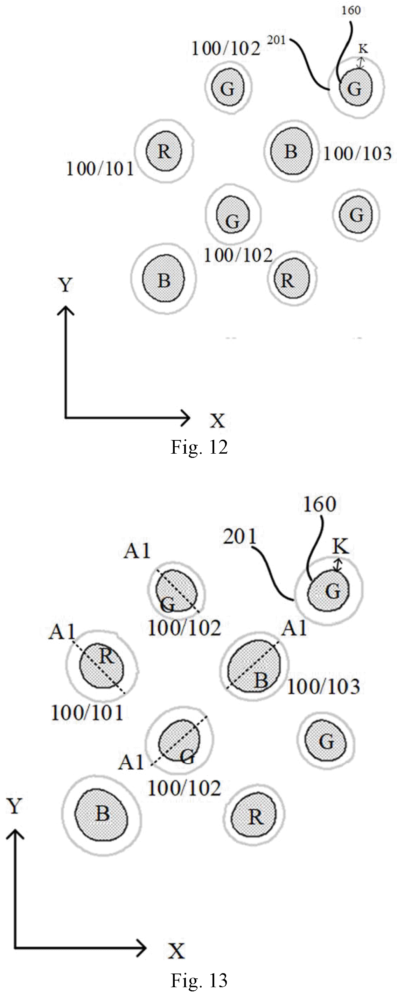

Fig. 12 is a plan view of a display panel provided by an embodiment of the present disclosure. Fig. 13 is a plan view of a display panel provided by an embodiment of the present disclosure. As shown in Figs. 12 and 13, the first sub-pixels 101, the second sub-pixels 102, and the third sub-pixels 103 all have an inverted elliptical shape.

As shown in Fig. 12, different sub-pixels have different outward values K. For an inverted ellipse, similar to a circle, the outward value K is the distance between the orthographic projection of the opening of the black matrix on the base substrate and the orthographic projection of the light-emitting region of the sub-pixel on the base substrate. For example, the same sub-pixel may have the same outward value K at various locations, but is not limited thereto.

As shown in Fig. 13, based on the different outward values K of different sub-pixels, the major axes A1 of the openings 201 have M orientations, where M is a positive integer greater than or equal to 2. In Fig. 13, the major axes A1 have two orientations: one at 45° relative to the direction X, and the other at 135° relative to the direction X. For example, the openings 201 and light-emitting regions 160 may be ellipses or circles with different eccentricities. Four sub-pixels marked with major axes A1 in Fig. 13 constitute one repeating sub-unit, which may form a 2×2 array or a 4×4 array as a repeating unit.

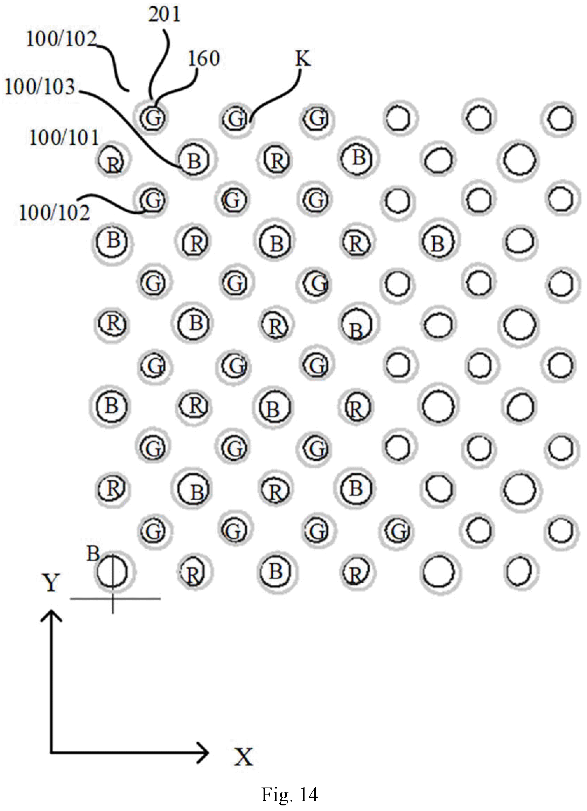

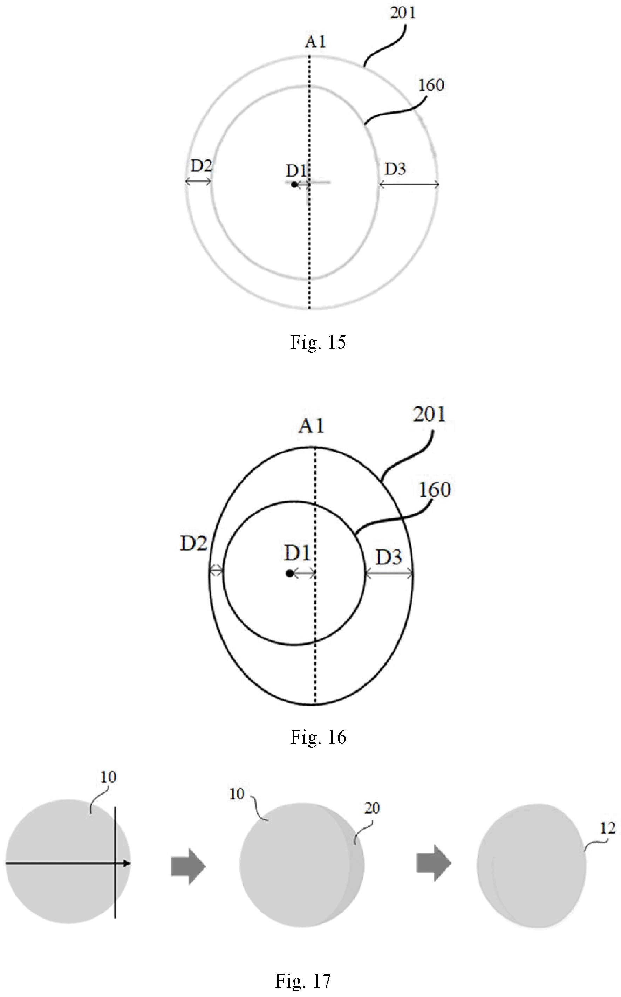

Fig. 14 is a plan view of a display panel provided by an embodiment of the present disclosure. Fig. 15 is a plan view of a sub-pixel in a display panel provided by an embodiment of the present disclosure. Fig. 16 is a plan view of a sub-pixel in a display panel provided by an embodiment of the present disclosure. In Fig. 15, the light-emitting region 160 has an inverted elliptical shape, and the opening 201 of the black matrix is circular. In Fig. 16, the light-emitting region 160 is circular, and the opening 201 of the black matrix has an inverted elliptical shape. Of course, in other embodiments, the light-emitting region 160 and the opening 201 of the black matrix may have the same shape, for example, both being circular or both being inverted elliptical. In some embodiments, the light-emitting regions 160 of sub-pixels of one color may have one shape, while the light-emitting regions 160 of sub-pixels of other colors may have another shape. In some embodiments, the openings 201 of sub-pixels of one color may have one shape, while the openings 201 of sub-pixels of other colors may have another shape.

For example, as shown in Figs. 14 to 16, at least one sub-pixel 100 has an opening 201 that is not concentric with the light-emitting region 160.

For example, as shown in Figs. 14 to 16, the center offset between the opening 201 and the light-emitting region 160 is 1.5-2 µm. Figs. 14 and 15 illustrate the major axis A1 of the opening 201. Figs. 14 and 15 also illustrate the center offset D1 between the opening 201 and the light-emitting region 160.

For example, as shown in Figs. 14 to 16, on opposite sides of the sub-pixel 100, the outward values K of the same sub-pixel 100 are different. As shown in Figs. 14 and 15, the outward value K on the left side of the sub-pixel is a distance D2, and the outward value K on the right side of the sub-pixel is a distance D3, where D2 is not equal to D3. For example, distance D2 is 1.5-2 µm, and distance D3 is 5-10 µm.

For example, the first sub-pixel 101 is a red sub-pixel, the second sub-pixel 102 is a green sub-pixel, and the third sub-pixel 103 is a blue sub-pixel.

Fig. 17 illustrates a forming process of an inverted elliptical shape provided by an embodiment of the present disclosure. As shown in Fig. 17, the inverted elliptical shape in the embodiment of the present disclosure refers to a shape formed by chamfering the edge of a circle 10, for example, rounding the corners, that is, the shape obtained after a crescent-shaped portion 20 is removed from the circle 10. The curvature radius of the chamfered edge 12 increases.

In the display panel provided by the present embodiment, the display panel satisfies at least one of the following three conditions with different outward values: at least two first sub-pixels 101 have different outward values, at least two second sub-pixels 102 have different outward values, or at least two third sub-pixels 103 have different outward values. That is, at least two sub-pixels emitting light of the same color have different outward values. This configuration can mitigate diffraction and improve display quality. This arrangement can be observed from Figs. 3, 4, 9, and the tables illustrating the outward values.

Some of the drawings in the present embodiment illustrate the direction X and the direction Y. Both the direction X and the direction Y are parallel to the main surface of the base substrate. The main surface of the base substrate is the surface used for manufacturing various components. The direction X intersects the direction Y; for example, the direction X is perpendicular to the direction Y. The direction Z is perpendicular to the main surface of the base substrate and is perpendicular to both the direction X and the direction Y.

The present embodiment provides a display apparatus including any of the display panels described above. The display apparatus provided by the present embodiment can be a medium- to large-sized display apparatus, but is not limited thereto.

For example, the display apparatus described above may be a television, a computer monitor, a laptop, a tablet, a mobile phone, a navigation device, an vehicle-mounted display, or other electronic products having a display function.

The above are only specific embodiments of the present disclosure, but the protection scope of the present disclosure is not limited thereto. Any person skilled in the art can easily conceive of changes or substitutions within the technical scope disclosed in the present disclosure, and these changes or substitutions should be covered within the protection scope of the present disclosure. Therefore, the protection scope of the present disclosure should be subject to the protection scope of the claims.

## Claims

1. A display panel, comprising:
a base substrate;
a plurality of sub-pixels located on the base substrate, each sub-pixel of the plurality of sub-pixels comprising a light-emitting region; and
a black matrix comprising a plurality of openings, one opening of the plurality of openings being correspondingly disposed outside the light-emitting region of each sub-pixel of the plurality of sub-pixels,
wherein at the same sub-pixel, a distance between an orthographic projection of the opening on the base substrate and an orthographic projection of the light-emitting region on the base substrate is an outward value, and
among sub-pixels adjacent to the same sub-pixel, at least three sub-pixels have outward values different from that of the sub-pixel.

2. The display panel according to claim 1, wherein the plurality of sub-pixels form a plurality of repeating units, each repeating unit of the plurality of repeating units comprises at least one repeating sub-unit, in the at least one repeating sub-unit, each repeating sub-unit comprises a first sub-pixel, a second sub-pixel, and a third sub-pixel, and each two of the first sub-pixel, the second sub-pixel, and the third sub-pixel have different light-emitting colors.

3. The display panel according to claim 2, wherein outward values of the first sub-pixel, the second sub-pixel, and the third sub-pixel in the same repeating sub-unit are different from one another.

4. The display panel according to claim 2 or 3, wherein each repeating unit of the plurality of repeating units comprises a plurality of repeating sub-units, and in at least three different repeating sub-units, outward values of first sub-pixels are different, outward values of second sub-pixels are different, and outward values of third sub-pixels are different.

5. The display panel according to any one of claims 2 to 4, wherein along an arrangement direction of three different repeating sub-units, outward values of first sub-pixels increase sequentially, outward values of second sub-pixels increase sequentially, and outward values of third sub-pixels increase sequentially.

6. The display panel according to claim 2, wherein outward values of sub-pixels in the same repeating sub-unit are identical, and outward values in at least three different repeating sub-units are different.

7. The display panel according to claim 6, wherein each repeating unit of the plurality of repeating units comprises six repeating sub-units, and the six repeating sub-units form a matrix of three rows and three columns; and in the matrix, in a row direction, in at least one row of repeating sub-units, outward values of three repeating sub-units are different from one another.

8. The display panel according to claim 7, wherein in a column direction, in at least one column of repeating sub-units, at least two different repeating sub-units have different outward values.

9. The display panel according to claim 8, wherein in the row direction, in each of the three rows of repeating sub-units, the outward values of the three repeating sub-units are different from one another; and in the column direction, in each of the three columns of repeating sub-units, the outward values of at least two different repeating sub-units are different.

10. The display panel according to claim 9, wherein in the column direction, in one column of the three columns of repeating sub-units, outward values of three different repeating sub-units are different from one another.

11. The display panel according to any one of claims 1 to 10, wherein the outward value is greater than or equal to 1 µm and less than or equal to 4 µm.

12. The display panel according to claim 1, wherein the plurality of sub-pixels comprise a plurality of first sub-pixels, a plurality of second sub-pixels, and a plurality of third sub-pixels, and each two of each of the plurality of first sub-pixels, each of the plurality of second sub-pixels, and each of the plurality of third sub-pixels have different light-emitting colors; and the display panel satisfies at least one of the following three conditions regarding different outward values: at least two first sub-pixels have different outward values, at least two second sub-pixels have different outward values, or at least two third sub-pixels have different outward values.

13. The display panel according to any one of claims 1 to 12, wherein a minimum gap between different outward values among a plurality of outward values is greater than or equal to 0.5 µm.

14. The display panel according to any one of claims 1 to 13, further comprising a color filter layer, wherein an insulating layer is disposed between the color filter layer and the black matrix, the color filter layer is closer to the base substrate than the black matrix, and the insulating layer covers the color filter layer.

15. The display panel according to any one of claims 1 to 14, wherein at least one opening among the plurality of openings is non-circular in shape, the opening of the black matrix has a major axis, a dimension of the opening in an extending direction of the major axis is a maximum dimension of the opening, and major axes of the plurality of openings have M orientations, where M is a positive integer greater than or equal to 2.

16. The display panel according to claim 15, wherein for at least one sub-pixel, the opening and the light-emitting region are not concentric.

17. The display panel according to claim 15 or 16, wherein a center offset between the opening and the light-emitting region is 1.5-2 µm.

18. The display panel according to any one of claims 15 to 17, wherein outward values of the same sub-pixel on opposite sides of the sub-pixel are different.

19. The display panel according to any one of claims 2 to 10, wherein the first sub-pixel is a red sub-pixel, the second sub-pixel is a green sub-pixel, and the third sub-pixel is a blue sub-pixel.

20. The display panel according to any one of claims 1 to 19, wherein the at least three sub-pixels comprise three sub-pixels having emission colors different from a central sub-pixel surrounded thereby.

21. The display panel according to any one of claims 1 to 20, wherein the at least three sub-pixels comprise at least one sub-pixel having an emission color the same as a central sub-pixel surrounded thereby.

22. The display panel according to any one of claims 1 to 21, wherein at least two sub-pixels emitting light of the same color have different outward values.

23. A display apparatus, comprising the display panel according to any one of claims 1 to 22.
